# EUROPEAN PATENT APPLICATION

(11) **EP 1 562 227 A1**
(43) Date of publication of application: **10.08.2005**
(21) Application number: 03772778.1
(22) Date of filing: 14.11.2003
(51) Int. Cl.: H01L 21/3205, H01L 21/78

(54) **SEMICONDUCTOR DEVICE**

(30) Priority: 15.11.2002 JP 2002332844
(71) Applicant: Kabushiki Kaisha Toshiba, Minato-ku, Tokyo 105-8001 (JP)
(72) Inventor: TAMURA, Itaru; c/o Intellectual Property division,, Minat o-ku, Tokyo 105-8001 (JP); MURAKAMI, Katsuya c/o Intellectual Property divisn, Minato-ku, Tokyo 105-8001 (JP); TAKEBE, Naoto, Chigasaki-shi, Kanagawa 253-0061 (JP)
(74) Representative: Midgley, Jonathan Lee
(86) International application number: PCT/JP2003/014513
(87) International publication number: WO 2004/047163

(57) **Abstract**

A semiconductor device using a low-dielectric-constant film whose dielectric constant k is 3.0 or lower for an interlayer film (14) includes a suppression mechanism unit (20) that suppresses film peeling of the interlayer film (14).

## Description

### Technical Field

This invention relates to a semiconductor device having a low-dielectric-constant (low-k) film whose dielectric constant k is 3.0 or lower. More specifically, the invention relates to an LSI (Large Scale Integrated Circuit) using a low-k film for an interlayer film.

### Background Art

An attempt to adopt a low-k film for an interlayer film has recently been made in an LSI using dual copper (Cu) damascene wiring.

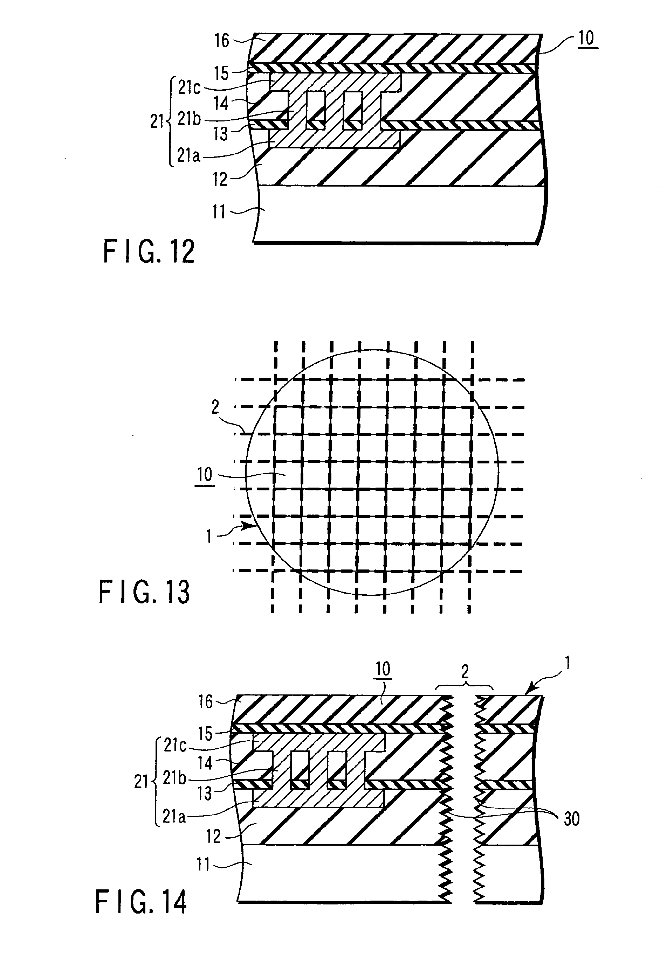

A method of manufacturing an LSI chip 10 with dual Cu damascene wiring adopting a low-k film for an interlayer film will be described with reference to FIG. 12. First, a first interlayer film 12 is deposited on a silicon (Si) substrate 11. A first wiring layer 21a is formed in a surface area of the first interlayer film 12 through a given damascene wiring process. Then, a stopper member (e.g., SiCN film) 13 and a low-k film (e.g., SiOC film) 14 of a second interlayer film are deposited in sequence on the first interlayer film 12 including the surface of the first wiring layer 21a. After that, a contact via 21b is formed in the low-k film 14 and stopper member 13 in contact with the first wiring layer 21a. A second wiring layer 21c is formed in a surface area of the low-k film 14 in contact with the via 21b through a given damascene wiring process. Thus, a dual damascene wiring structure (dual Cu damascene wiring) 21 is completed. After that, a stopper member 15 and a passivation film 16 are deposited in sequence.

A process of assembling the LSI chip 10 so manufactured will now be described. Usually, a plurality of LSI chips 10 are formed at once on a wafer 1 as shown in, e.g., FIG. 13. The wafer 1 is diced along the dicing lines (broken lines in the figure) corresponding to dicing portions 2. The LSI chips 10 manufactured as described above are separated from one another. The edge portions (dicing planes) of each of the LSI chips 10 are subjected to damage 30 by dicing as shown in, e.g., FIG. 14.

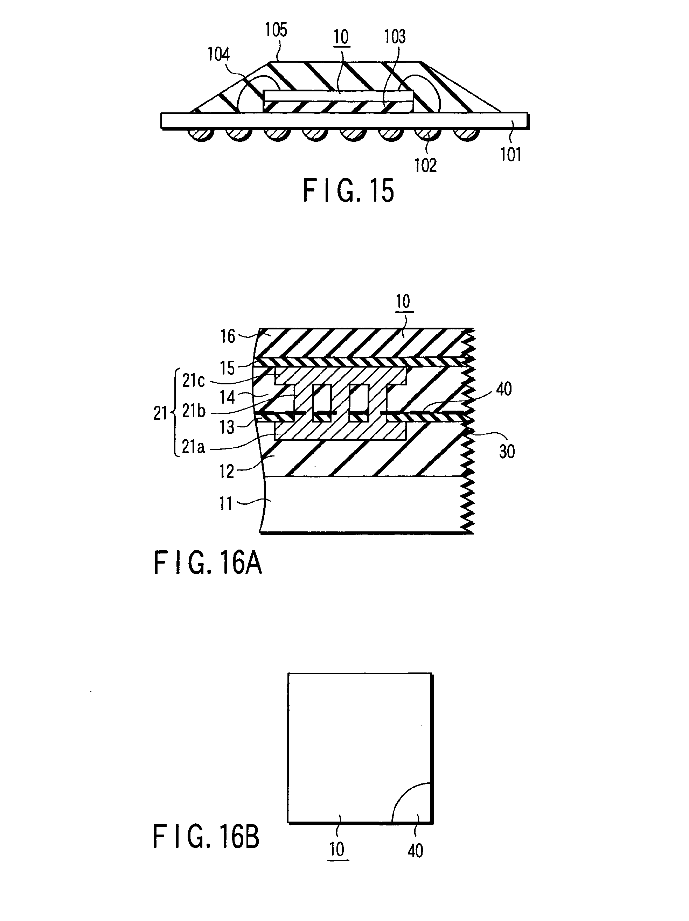

Each of the LSI chips 10 separated from one another is packaged as shown in, e.g., FIG. 15. In other words, each of the LSI chips 10 is mounted on a mounting substrate 101 using a mounting member 103. The electrode pads of each of the LSI chips 10 are connected to bump electrodes 102 on the mounting substrate 101 by bonding wires 104, respectively. After that, the circumference of each of the LSI chips 10 is sealed with sealing resin 105. Then, the sealing resin 105 is cured and shrunk.

In general, the low-k film 14 is low in film density and thus poor at the strength of adhesion to the stopper member 13 of the lower layer. Consequently, as shown in, e.g., FIG. 16A, the low-k film 14 is easy to cause peeling (interlayer-film peeling) 40 when the sealing resin 105 is cured and shrunk in the LSI chip 10. The interlayer-film peeling 40 is caused chiefly at an interface between the low-k film 14 and the stopper member 13, starting from the edge portions of the LSI chip 10, which are subjected to the damage 30 by dicing. In particular, when the sealing resin 105 is cured and shrunk, its stress is maximized at the corner portions of the LSI chip 10. Therefore, the interlayer-film peeling 40 is selectively generated from the corner portions of the LSI chip 10, as shown in, e.g., FIG. 16B. The generated interlayer-film peeling 40 disconnects the wiring structure 21 in the LSI chip 10. This disconnection brings about poor wiring and decreases the yield of the LSI chips 10.

Even though the interlayer-film peeling 40 is a slight one immediately after the assembly process, an LSI is likely to break down in the future. More specifically, when an LSI chip is used, stress is applied to the LSI chip 10 by a difference in temperature caused by the on/off of a power supply. Then, the stress advances the interlayer-film peeling 40 and consequently the LSI will break down.

As described above, the prior art LSI chip has the problem that an interlayer film is easy to peel off the interface of the low-k film, especially the corner portions of the chip, though an attempt to adopt the low-k film for the interlayer film is made. This problem stems from poor adhesion due to a low film density of the low-k film and damage to the chip at the time of dicing. As described above, when the chips are assembled and mounted and their products are used, interlayer-film peeling is caused to break down an LSI. It is thus desired that effective measures be taken to suppress the interlayer-film peeling.

### Disclosure of Invention

An object of the present invention is to provide a semiconductor device capable of suppressing interlayer-film peeling due to low film density of a low-k film and damage at the time of dicing and preventing an LSI from breaking down by the interlayer-film peeling.

According to an embodiment of the present invention, there is provided a semiconductor device using a low-dielectric-constant film whose dielectric constant k is 3.0 or lower for an interlayer film, characterized by comprising a suppression mechanism unit which suppresses film peeling of the interlayer film.

Even though a low-k film is used for an interlayer film, the interlayer film can be prevented from peeling off and the peeling can be prevented from advancing. It is therefore possible to resolve a problem of a disconnection of the internal wiring structure at the time of assembly, its subsequent mounting and use of products.

### Brief Description of Drawings

FIGS. 1A to 1E are diagrams showing an example of an LSI chip according to a first embodiment of the present invention.
FIGS. 2A to 2E are plan views showing an example of a reinforcing pattern in an LSI chip according to a second embodiment of the present invention.
FIGS. 3A to 3E are plan views showing another example of the reinforcing pattern in the LSI chip according to the second embodiment of the present invention.
FIG. 4 is a plan view showing an example of an LSI chip having a reinforcing pattern formed by combining the reinforcing patterns according to the first and second embodiments.
FIGS. 5A to 5D are diagrams showing an example of an LSI chip according to a third embodiment of the present invention.
FIGS. 6A to 6E are plan views showing an example of a reinforcing pattern in an LSI chip according to a fourth embodiment of the present invention.
FIGS. 7A to 7C are plan views showing another example of the reinforcing pattern in the LSI chip according to the fourth embodiment of the present invention.
FIG. 8 a plan view showing an example of an LSI chip having a reinforcing pattern formed by combining the reinforcing patterns according to the first and fourth embodiments.
FIG. 9 is a plan view showing an example of an LSI chip having a reinforcing pattern formed by combining the reinforcing patterns according to the third and fourth embodiments.
FIGS. 10A to 10D are diagrams showing an example of an LSI chip according to a fifth embodiment of the present invention.
FIGS. 11A to 11C are diagrams showing an example of an LSI chip according to a sixth embodiment of the present invention.
FIG. 12 is a sectional view of an LSI chip to explain prior art and its problems.
FIG. 13 is a plan view of a wafer that has not yet cut into LSI chips by dicing.
FIG. 14 is a sectional view of an LSI chip to explain damage caused by dicing.
FIG. 15 is a sectional view showing an example of packaging of an LSI chip.
FIGS. 16A and 16B are diagrams of an LSI chip to explain interlayer-film peeling.

### Best Mode for Carrying Out the Invention

Embodiments of the present invention will be described below with reference to the drawings.

### [First Embodiment]

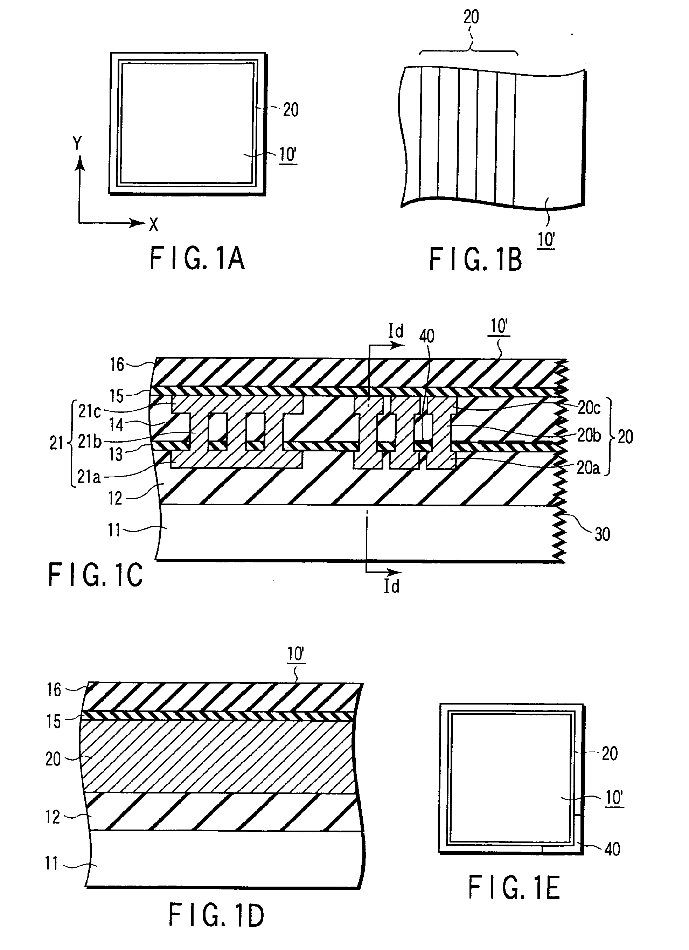

FIGS. 1A to 1E show an example of a structure of an LSI chip according to a first embodiment of the present invention. The first embodiment is applied to an LSI chip (refer to, e.g., FIG. 12) with dual Cu damascene wiring adopting a low-k film for an interlayer film.

In FIG. 1A, a reinforcing pattern 20 is formed in the peripheral portion of an LSI chip 10' as a suppression mechanism unit to prevent interlayer-film peeling from advancing. The reinforcing pattern 20 is formed of a plurality of (three in this embodiment) dummy wiring patterns as shown in, e.g., FIG. 1B. Each of the dummy wiring patterns is formed to have a dual damascene wiring structure as shown in, e.g., FIG. 1C. More specifically, each of the dummy wiring patterns is formed of first and second Cu layers 20a and 20c and a via 20b that connects the first and second Cu layers 20a and 20c to each other. FIG. 1D shows a side portion of the reinforcing pattern 20 (a section taken along line Id - Id of FIG. 1C).

A method of manufacturing an LSI chip 10' having a reinforcing pattern 20 as described above will be described with reference to FIG. 1C. First, a first interlayer film 12 is deposited on a Si substrate 11. A first wiring layer 21a that is made of Cu and a first Cu layer 20a are formed in a surface area of the first interlayer film 12 through a given damascene wiring process. Then, a stopper member (e.g., SiCN film) 13 is deposited on the first interlayer film 12 including the surface of the first wiring layer 21a and that of the first Cu layer 20a. A low-k film (e.g., SiOC film of a low-dielectric-constant film whose dielectric constant k is 3.0 or lower) 14 is deposited as a second interlayer film on the stopper member 13. After that, a contact via 21b is formed in the low-k film 14 and stopper member 13 in contact with the first wiring layer 21a, while a contact via 20b is formed therein in contact with the first Cu layer 20a. A second wiring layer 21c and a second Cu layer 20c are formed in contact with the via 21b and via 20b, respectively through a given damascene wiring process. Thus, a dual damascene wiring structure 21 that is made of Cu (dual Cu damascene wiring) is completed simultaneously with the reinforcing pattern 20 having almost the same structure as that of the wiring structure 21. The reinforcing pattern 20 by which the interface of the low-k film 14 is partly removed is formed to surround, for example, the peripheral portion of the LSI chip 10'. After that, a stopper member 15 and a passivation film 16 are deposited in sequence.

The LSI chip 10' manufactured as described above is very strengthened by the reinforcing pattern 20 of the peripheral portion to suppress interlayer-film peeling 40, which is caused by poor adhesion to the stopper member 13 (or stopper member 15) due to a low film density of the low-k film 14 and damage 30 due to dicing. Even though the interlayer-film peeling 40 is generated from the edge portions (especially corner portions) of the LSI chip 10', the reinforcing pattern 20 can prevent the interlayer-film peeling 40 from advancing, as shown in FIG. 1E. It is thus possible to prevent a breakdown of an LSI, such as a disconnection of the wiring structure 21 in the LSI chip 10' due to the advance of the interlayer-film peeling 40, even after the assembly process as well as at the time thereof.

Particularly, in the present embodiment, the reinforcing pattern 20 has a dual Cu damascene wiring structure and can be formed simultaneously with the wiring structure 21 through the same process. For this reason, the LSI chip 10' can easily be achieved without adding any process or requiring any complicated control. Needless to say, the reinforcing pattern 20 need not always be formed to have a dual Cu damascene wiring structure. The reinforcing pattern 20 can be formed by wiring materials other than Cu.

### [Second Embodiment]

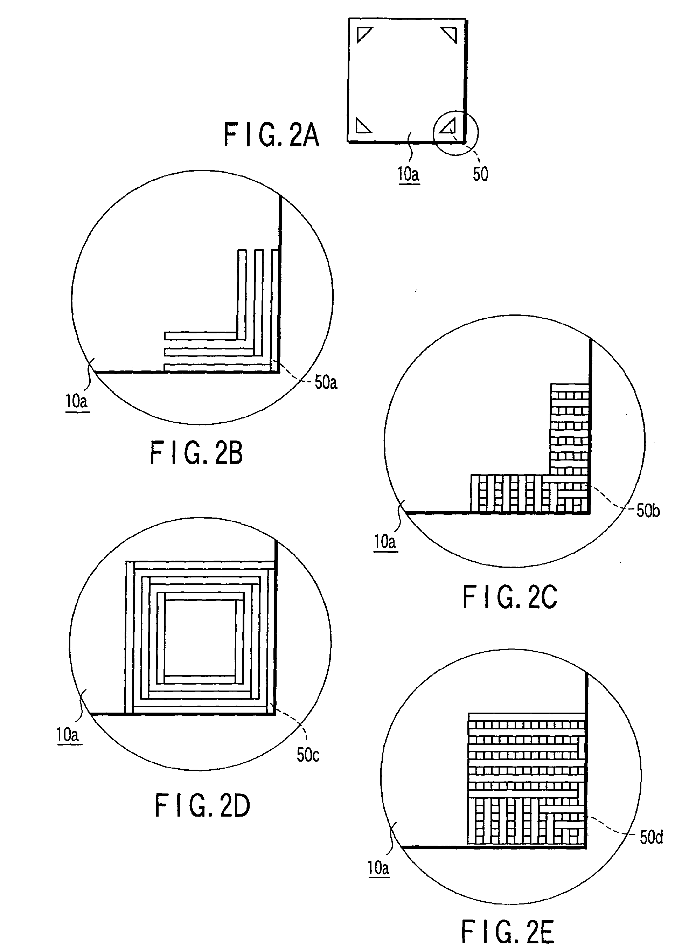

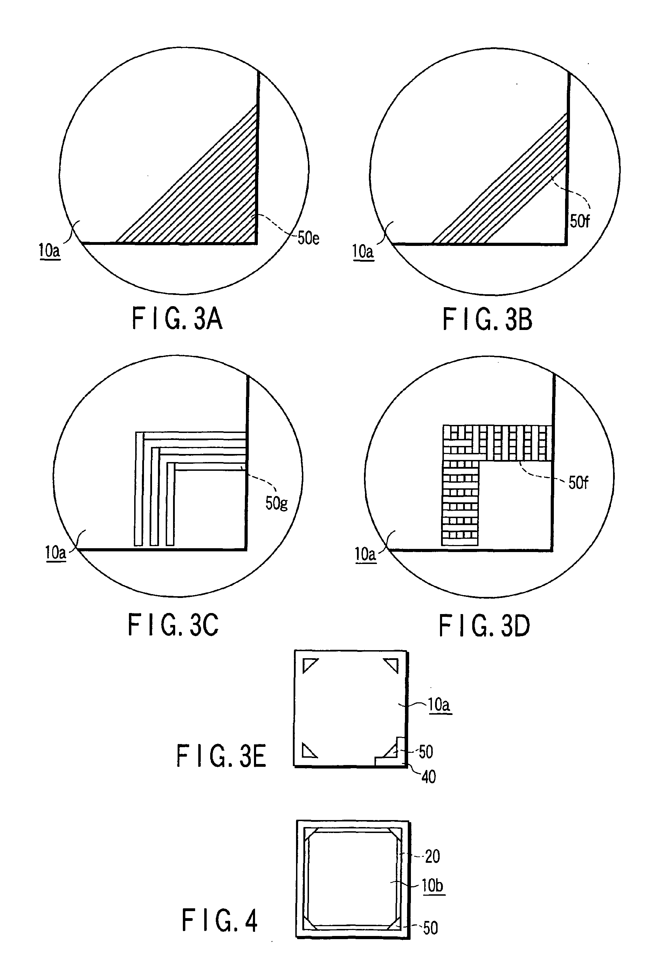

FIGS. 2A to 2E and FIGS. 3A to 3E show an example of a structure of an LSI chip according to a second embodiment of the present invention. The second embodiment is applied to an LSI chip (see, for example, FIG. 12) with dual Cu damascene wiring adopting a low-k film for an interlayer film. The LSI chip has reinforcing patterns (wiring patterns) 50 in its corner portions as suppression mechanism units.

As shown in FIG. 2A, an LSI chip 10a includes reinforcing patterns 50 in its corner portions to prevent interlayer-film peeling from advancing. The reinforcing patterns 50 are formed in their respective corner portions of the LSI chip 10a to eliminate an interface partly from the low-k film. Different dummy wiring patterns 50a to 50h can be used as the reinforcing patterns 50 as illustrated in, e.g., FIGS. 2B to 2E and 3A to 3D. The dummy wiring patterns 50a to 50h each have a dual damascene wiring structure that is made of Cu, as in the first embodiment, for example.

The reinforcing patterns 50 are particularly formed in the corner portions of the LSI chip 10a from which an interlayer film is easy to peel. The same advantages as those of the LSI chip 10' in the above first embodiment can be expected. That is, the reinforcing patterns 50 can prevent interlayer-film peeling 40 from advancing as shown in FIG. 3E. It is thus possible to prevent a breakdown of an LSI, such as a disconnection of the wiring structure in the LSI chip 10a due to the advance of the interlayer-film peeling 40, even after the assembly process as well as at the time thereof.

Furthermore, the reinforcing patterns 50 of the second embodiment can be used in combination with the reinforcing pattern 20 of the first embodiment described above. For example, as shown in FIG. 4, the reinforcing pattern 20 of the first embodiment and the reinforcing patterns 50 of the second embodiment are arranged in an LSI chip 10b. With this arrangement, the reinforcing patterns 20 and 50 can prevent interlayer-film peeling from advancing more reliably.

### [Third Embodiment]

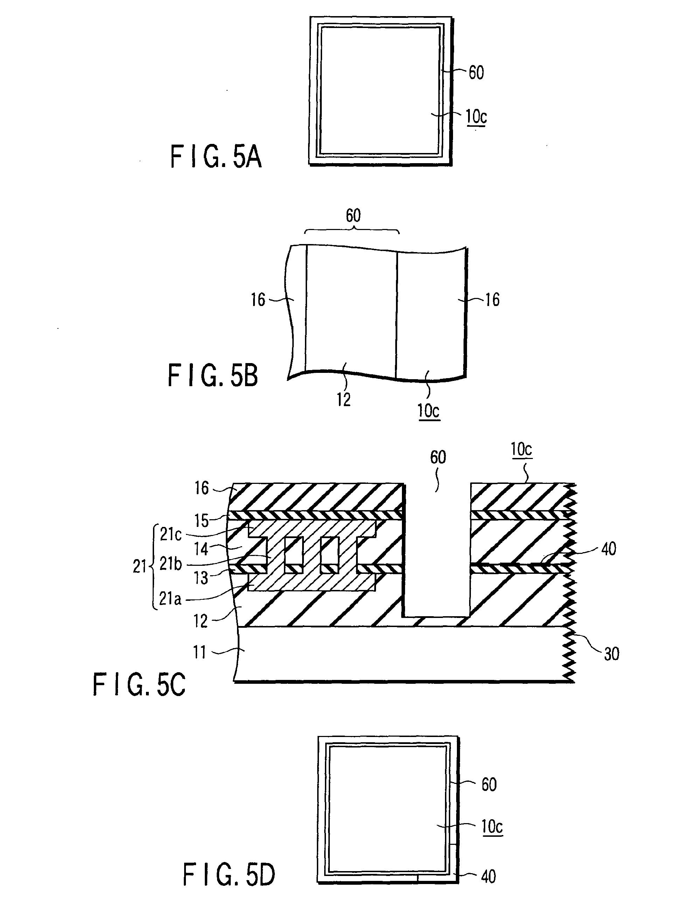

FIGS. 5A to 5D show an example of a structure of an LSI chip according to a third embodiment of the present invention. The third embodiment is applied to an LSI chip (see, for example, FIG. 12) with dual Cu damascene wiring adopting a low-k film for an interlayer film. A reinforcing pattern (opening pattern) 60 is formed in the peripheral portion of the LSI chip as a suppression mechanism unit.

As shown in FIGS. 5A and 5B, the reinforcing pattern 60 is formed in the peripheral portion of the LSI chip 10c to prevent interlayer-film peeling from advancing. The reinforcing pattern 60 is formed as a trench having a depth that reaches at least a first interlayer film 12 as shown in, e.g., FIG. 5C. In other words, the reinforcing pattern 60 is formed to partly remove an interface between a stopper member 13 and a low-k film 14 by etching, a laser or the like. Thus, the reinforcing pattern 60, which corresponds to an opening pattern by which the low-k film 14 is partly removed, is formed to surround the peripheral portion of the LSI chip 10c.

Almost the same advantages as those of the above first and second embodiments can also be expected by the reinforcing pattern 60. In other words, the reinforcing pattern 60 allows the edge portions of the LSI chip 10c and the wiring structure 21 therein to be physically separated from each other. Thus, even though interlayer-film peeling 40 is caused by damage 30 due to dicing as shown in, e.g., FIGS. 5C and 5D, the reinforcing pattern 60 can prevent the interlayer-film peeling 40 from advancing further. It is thus possible to prevent a breakdown of an LSI, such as a disconnection of the wiring structure 21 in the LSI chip 10c due to the advance of the interlayer-film peeling 40, even after the assembly process as well as at the time thereof.

### [Fourth Embodiment]

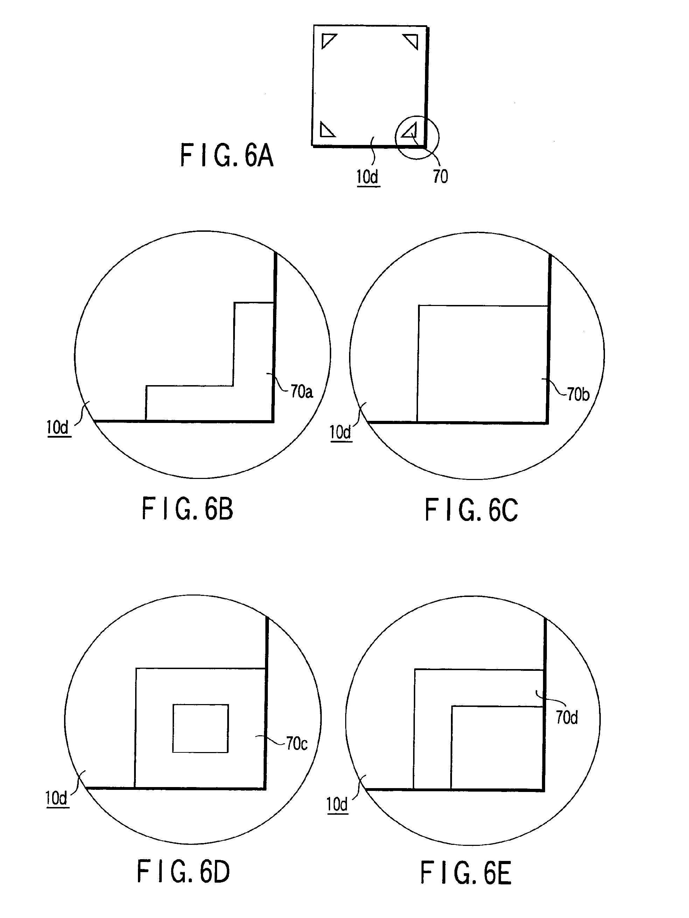

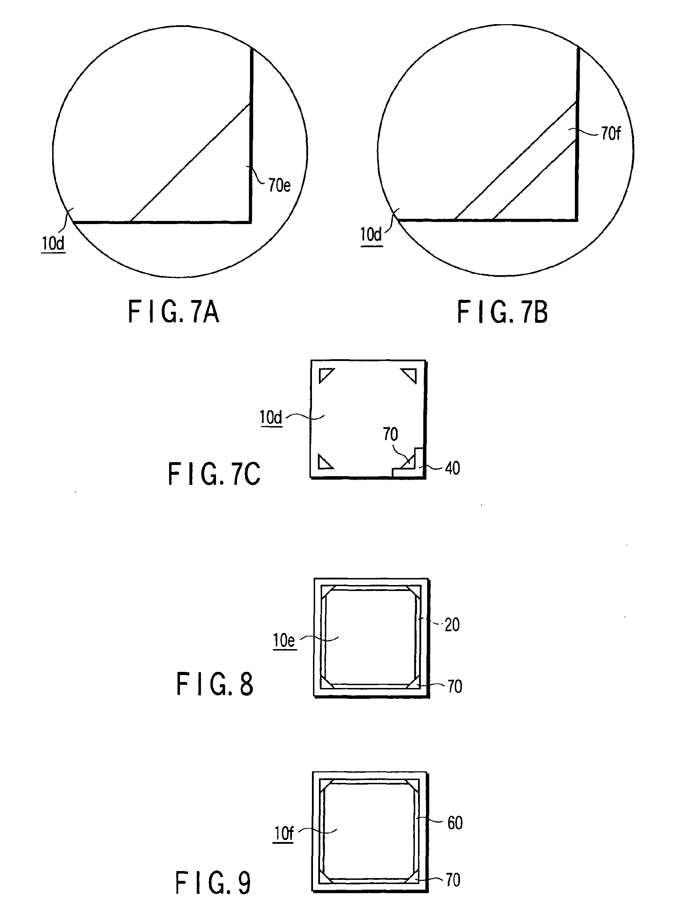

FIGS. 6A to 6E and FIGS. 7A to 7C each show an example of a structure of an LSI chip according to a fourth embodiment of the present invention. The fourth embodiment is applied to an LSI chip (see, for example, FIG. 12) with dual Cu damascene wiring adopting a low-k film for an interlayer film. Reinforcing patterns (opening patterns) 70 are formed in their respective corner portions of the LSI chip as suppression mechanism units.

As shown in FIG. 6A, an LSI chip 10d includes reinforcing patterns 70 in its corner portions to prevent interlayer-film peeling from advancing. The reinforcing patterns 70 are each formed as a trench having a depth that reaches at least a first interlayer film 12 as shown in, e.g., FIG. 5C. Different opening patterns 70a to 70f can be used as the reinforcing patterns 70 as illustrated in, e.g., FIGS. 6B to 6E and 7A and 7B. In other words, the opening patterns 70a to 70f are formed to partly remove an interface between a low-k film and a stopper member by etching, a laser or the like, as in the above third embodiment, for example.

The reinforcing patterns 70 are particularly formed in the corner portions of the LSI chip 10d from which an interlayer film is easy to peel. Almost the same advantages as those of the above first to third embodiments can be expected. That is, the reinforcing patterns 70 can prevent interlayer-film peeling 40 from advancing further as shown in FIG. 7C. It is thus possible to prevent a breakdown of an LSI, such as a disconnection of the wiring structure in the LSI chip 10d due to the advance of the interlayer-film peeling 40, even after the assembly process as well as at the time thereof.

Furthermore, the reinforcing patterns 70 of the fourth embodiment can be used in combination with the reinforcing pattern 20 of the first embodiment described above. For example, the reinforcing pattern 20 of the first embodiment and the reinforcing patterns 70 of the fourth embodiment are arranged in an LSI chip 10e as shown in FIG. 8. With this arrangement, the reinforcing patterns 20 and 70 can prevent interlayer-film peeling from advancing more reliably.

Moreover, the reinforcing patterns 70 of the fourth embodiment can be used in combination with the reinforcing pattern 60 of the third embodiment described above. For example, the reinforcing pattern 60 of the third embodiment and the reinforcing patterns 70 of the fourth embodiment are arranged in an LSI chip 10f shown in FIG. 9. With this arrangement, the reinforcing patterns 60 and 70 can prevent interlayer-film peeling from advancing more reliably.

### [Fifth Embodiment]

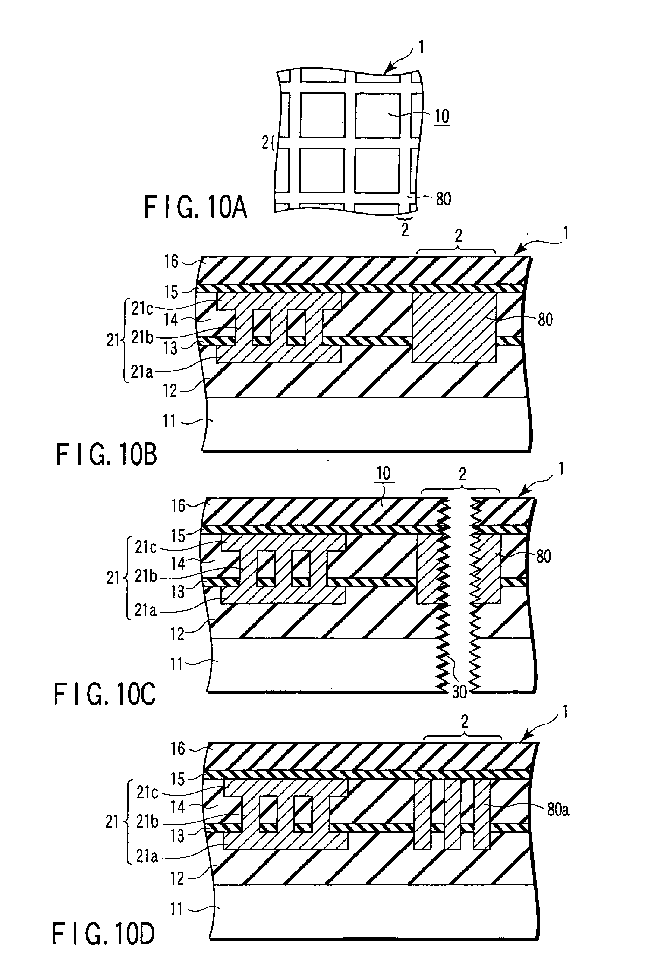

FIGS. 10A to 10D show an example of a structure of an LSI chip according to a fifth embodiment of the present invention. The fifth embodiment is applied to an LSI chip (see, for example, FIG. 12) with dual Cu damascene wiring adopting a low-k film for an interlayer film. A reinforcing pattern (wiring pattern) 80 is formed on the periphery of the chip (dicing portion of a wafer) as a suppression mechanism unit.

As shown in FIG. 10A, an LSI chip 10 has a reinforcing pattern 80 on the periphery thereof or a dicing portion 2 of a wafer 1 to inhibit interlayer-film peeling from occurring. The reinforcing pattern 80 is formed of a single Cu-made wiring pattern to partly remove an interface from at least a low-k film 14, as shown in, e.g., FIG. 10B.

The reinforcing pattern 80 is particularly formed on the dicing portion 2 of the wafer 1 that is susceptible to damage 30 at the time of dicing. Almost the same advantages as those of the above first to fourth embodiments can thus be expected. In other words, the reinforcing pattern 80 can absorb the damage 30 at the time of dicing as shown in FIG. 10C, or the damage 30 due to dicing can be prevented from being directly applied to the interface of the low-k film 14. Consequently, interlayer-film peeling 40 can be inhibited from occurring. It is thus possible to resolve a problem of a disconnection of the wiring structure 21 in the LSI chip 10 due to the occurrence of the interlayer-film peeling 40, even after the assembly process as well as at the time thereof.

The reinforcing pattern 80 is not limited to one that is formed by a single wiring pattern. For example, as shown in FIG. 10D, it can be applied to a reinforcing pattern 80a that is formed of a plurality of (three in this case) wiring patterns and, in this case, the same advantages can be obtained.

In either case, Cu is used to form the reinforcing patterns 80 and 80a and the LSI chip 10 can easily be achieved without adding any process or requiring any complicated control. Needless to say, the reinforcing patterns 80 and 80a can be formed to have a dual Cu damascene wiring structure as in the first embodiment. The reinforcing patterns 80 and 80a can be formed by wiring materials other than Cu.

### [Sixth Embodiment]

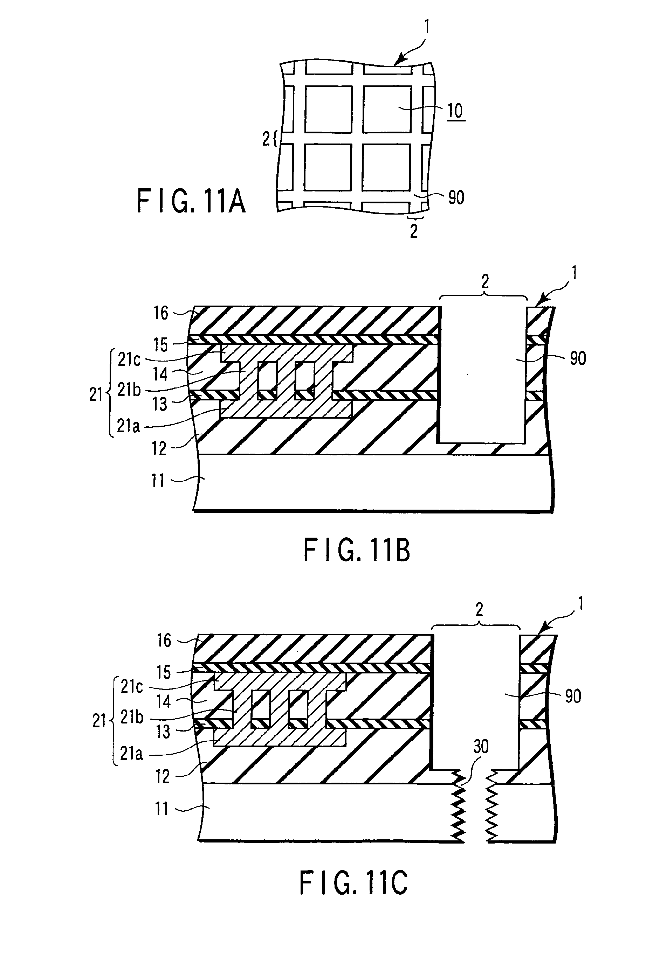

FIGS. 11A to 11C show an example of a structure of an LSI chip according to a sixth embodiment of the present invention. The sixth embodiment is applied to an LSI chip (see, for example, FIG. 12) with dual Cu damascene wiring adopting a low-k film for an interlayer film. A reinforcing pattern (opening pattern) 90 is formed on the periphery of the chip (dicing portion of a wafer) as a suppression mechanism unit.

As shown in FIG. 11A, an LSI chip 10 has a reinforcing pattern 90 on the periphery thereof or the dicing portion 2 of a wafer to inhibit interlayer-film peeling from occurring. The reinforcing pattern 90 is formed of a single trench to partly remove an interface from at least a low-k film 14 by etching, a laser or the like, as shown in, e.g., FIG. 11B.

The reinforcing pattern 90 is particularly formed on the dicing portion 2 of the wafer 1 that is susceptible to damage 30 at the time of dicing. Almost the same advantages as those of the above first to fourth embodiments can thus be expected. In other words, as shown in FIG. 11C, the reinforcing pattern 90 can prevent the damage 30 due to the dicing from being directly applied to the interface of the low-k film 14. Consequently, interlayer-film peeling can be inhibited from occurring. It is thus possible to resolve a problem of a disconnection of the wiring structure 21 in the LSI chip 10 due to the occurrence of the interlayer-film peeling, even after the assembly process as well as at the time thereof.

The reinforcing pattern 90 is not limited to one that is formed by a single opening pattern (trench). Even if the reinforcing pattern 90 is formed of, e.g., a plurality of opening patterns, the same advantages can be obtained.

The present invention is not limited to the above embodiments, but various modifications can be made without departing from the subject matter of the invention in the stages of reduction to practice. The above embodiments contain inventions in various stages and these inventions can be extracted from appropriate combinations of a plurality of components disclosed in the embodiments. Even though some of all the components shown in the embodiments are deleted, the structure of the remaining components can be extracted as an invention if (at least one of) the problems of the invention can be resolved and (at least one of) the advantages of the invention is obtained.

### Industrial Applicability

According to an embodiment of the present invention, there can be provided a semiconductor device capable of suppressing interlayer-film peeling due to low film density of a low-k film and damage at the time of dicing and preventing an LSI from breaking down by the interlayer-film peeling.

## Claims

1. A semiconductor device using a low-dielectric-constant film whose dielectric constant k is 3.0 or lower for an interlayer film, **characterized by** comprising a suppression mechanism unit which suppresses film peeling of the interlayer film.

2. The semiconductor device according to claim 1, **characterized in that** the suppression mechanism unit includes a region which partly has no interface between the interlayer film and a lower film and/or an upper film of the interlayer film.

3. The semiconductor device according to claim 2, **characterized in that** the suppression mechanism unit is a reinforcing pattern formed at least in a peripheral portion of a chip.

4. The semiconductor device according to claim 2, **characterized in that** the suppression mechanism unit is a reinforcing pattern continuously surrounding a peripheral portion of a chip.

5. The semiconductor device according to one of claims 3 and 4, **characterized in that** the reinforcing pattern includes a plurality of metal walls using a wiring layer and a via layer of the semiconductor device.

6. The semiconductor device according to one of claims 3 and 4, **characterized in that** the reinforcing pattern has a damascene structure that is equal to that of two or more damascene wiring layers of the semiconductor device.

7. The semiconductor device according to claim 2, **characterized in that** the suppression mechanism unit is reinforcing patterns formed at least in corner portions of a chip.

8. The semiconductor device according to claim 2, **characterized in that** the suppression mechanism unit is an opening pattern formed at least in a peripheral portion of a chip.

9. The semiconductor device according to claim 2, **characterized in that** the suppression mechanism unit is an opening pattern continuously surrounding an outer region of a chip.

10. The semiconductor device according to claim 2, **characterized in that** the suppression mechanism unit is opening patterns formed at least in corner portions of a chip.

11. The semiconductor device according to claim 2, **characterized in that** the suppression mechanism unit is a reinforcing pattern formed at least at a dicing portion of a wafer.

12. The semiconductor device according to claim 11, **characterized in that** the reinforcing pattern is a metal wall using a wiring layer and a via layer of the semiconductor device.

13. The semiconductor device according to claim 11, **characterized in that** the reinforcing pattern is formed by same wiring materials as those of two or more damascene wiring layers of the semiconductor device.

14. The semiconductor device according to claim 2, **characterized in that** the suppression mechanism unit is an opening pattern formed at least on a dicing portion of a wafer.
